(19) Europäisches Patentamt
European Patent Office
Office européen des brevets

(11) EP 1 538 588 A2

(12) EUROPEAN PATENT APPLICATION

(43) Date of publication:
08.06.2005 Bulletin 2005/23

(51) Int Cl.⁷: G09G 3/00

(21) Application number: 04011377.1

(22) Date of filing: 13.05.2004

(84) Designated Contracting States:
AT BE BG CH CY CZ DE DK EE ES FI FR GB GR HU IE IT LI LU MC NL PL PT RO SE SI SK TR
Designated Extension States:
AL HR LT LV MK

(30) Priority: 25.11.2003 JP 2003394229
18.02.2004 JP 2004040981

(71) Applicant: Tohoku Pioneer Corp.
Tendo-shi, Yamagata 994-8585 (JP)

(72) Inventors:
• Satoh, Kazuhiro
Yonezawa-shi Yamagata 992-1128 (JP)
• Sato, Hiroyuki
Yonezawa-shi Yamagata 992-1128 (JP)
• Murakata, Masaki
Yonezawa-shi Yamagata 992-1128 (JP)

(74) Representative: HOFFMANN - EITLE
Patent- und Rechtsanwälte
Arabellastrasse 4
81925 München (DE)

(54) **Self-light-emitting display module and method for verifying defect state of the same**

(57) A self-light-emitting display module by which a defect can be quickly notified to a user, for example, when the defect is caused in a pixel on a display panel is provided. A routine for verifying whether a defect is caused on a signal line including a pixel on the display panel, and the like is executed when, for example, operating power is supplied to the self-light-emitting display module; or on a regular basis under a state in which the operating power is supplied; or when ON-operation of a detecting switch is executed by a user; and the like. A circuit for generating a reverse bias voltage is used as a current source. A defect state of a pixel, signal lines including the pixels and the like is recognized by a wave form of a current when the current is applied to an EL element in a non-light-emitting direction. When a defect is detected, a defect notification unit is operated.

FIG.1

EP 1 538 588 A2

**Description**

BACKGROUND OF THE INVENTION

Field of the Invention

The present invention relates to a self-light-emitting display module comprising a light-emitting display panel using, for example, an organic EL (electronic luminescence) element as a light-emitting element, and a lighting drive device which drives the panel for lighting, and, more particularly, to a self-light-emitting display module provided with a function by which a defect state of the light-emitting display panel or the lighting drive device, or a connecting portion between the light-emitting display panel and the lighting drive device can be verified during operating the self-light-emitting display module, or at arbitrary timing such as the start of operation and a method for verifying a defect state of the module.

Description of the Related Art

Recently, many of electronic devices and the like have been provided with a display. The display has been necessary and indispensable as a man-machine interface for a device supporting an informationalized society when the above-described display is used in a field, for example, for medical devices and measuring instruments of an aircraft, which a malfunction in the display might affect people's lives, the reliability of the display has been more severely required than that of a display adopted for a consumer apparatus such as a cellular phone and a car audio.
For example, in the case of an injector for pharmaceuticals, there may be caused a problem that it is impossible to decide whether a displayed figure is "0" or "8" when a lightness leak phenomenon is generated in the direction of scanning lines in a figure-displaying portion showing an injection amount. Moreover, there may be caused another problem that a number in an erroneous state is read because a pixel (picture element) showing a decimal point is not lighted and the number is misplaced to cause erroneous display of the wrong number. It is extremely dangerous that a user continues to use the above-described injector under recognition that such a wrong number is a correct one, and it is obvious that there is a possibility that the above-described continuous use causes a serious problem.
Then, there has been disclosed a configuration (See, for example, Japanese Patent Publication No. 3437152) for a display used in an electronic device for the above-described field. By the configuration, it is inspected in a semifinished state of a product before shipping the product whether each pixel has a defect, and it is determined whether the degree of the defect can meet a reference value for the product provided with the display.
Incidentally, the object of the invention disclosed in Japanese Patent Publication No. 3437152 is to evaluate each pixel on a display panel in a semifinished state of a product before shipping the product, and its subject is to provide an evaluation device which uses a driving circuit for inspecting an organic EL display to obtain evaluation results with high reliability.
When the evaluation device disclosed in Japanese Patent Publication No. 3437152 is used, there has been an advantage that an initial failure of the device can be prevented, but such an EL display has had a problem that a defect is newly caused in a pixel arranged in the display panel during operating a device provided with the display after shipping the device. Moreover, in addition to the above-described problem that a defect is newly caused in a pixel arranged in the display panel during the operation, there may be caused another problem that another defect is generated even in a drive device including data drive and a scanning drive for lighting drive of each pixel arranged on the display panel, or a connecting portion between the display panel and the drive device. Accordingly, there have been various kinds of measures by which the above problems are caused at a minimum possibility and the reliability is secured. However, there have been a lot of technical problems in order to solve the above-described problem that a defect is caused during operating a display, or another failure is generated in the above-described drive device and the like it is obvious that it is difficult to provide a display module without causing the above-described defect after shipping a product provided with the module.

SUMMARY OF THE INVENTION

The present invention has been made, noting the above-described actual problems, and its object is to provide a self-light-emitting module which comprises, for example, a function by which a defect in a pixel on the display panel and the like can be verified at arbitrary timing during operation of, at the start of a light-emitting display panel, and the like, and by which prevention of erroneous display information from being given to a user can be realized by notifying the defect to the user when the defect in a pixel and the like is caused; and a method for verifying the defect in the above module.
A self-light-emitting module according to the present invention which has been made in order to achieve the above obj ect, as described in a first aspect, comprises a light-emitting display panel in which a number of pixels using a self-light-emitting element with an electric polarity are arranged in a matrix manner, and a lighting drive device for selective lighting drive of the self-light-emitting elements on the light-emitting display panel, and is characterized in that a malfunction detection unit, by which malfunction in light emitting caused by defects in the light-emitting display panel, the lighting drive device, or a connecting portion between the light-emitting display panel and the lighting drive device is detected, is further provided.

Moreover, a method for verifying a defect state of a self-light-emitting display module according to the present invention which has been made in order to achieve the above object, as described in an eighteenth aspect, comprises a light-emitting display panel in which a number of pixels using a self-light-emitting element with an electric polarity are arranged in a matrix manner, a lighting drive device for selective lighting drive of the self-light-emitting elements on the light-emitting display panel, a malfunction detection unit, by which malfunction in light emitting caused by defects in the light-emitting display panel, the lighting drive device, or a connecting portion between the light-emitting display panel and the lighting drive device is detected, and is characterized in that the malfunction detection unit sequentially executes a charge discharge step at which charges accumulated in the self-light-emitting elements arranged on the light-emitting display panel are discharged; a current supply step at which a current is supplied in a non-light-emitting direction of the element concerned to the self-light-emitting under a state in which charges are discharged; a current-value measure step at which a value of a current passing in a pixel including the self-light-emitting element after a predetermined time has passed from the starting point for supplying the current; and a determination step at which the presence of a defect in the light-emitting display panel, the lighting drive device, or the connecting portion between the light-emitting display panel and the lighting drive device is determined by a value of a current measured at the current-value measure step, and a storage notification unit is activated according to the defect state determined at the determination step.

BRIEF DESCRIPTION OF THE DRAWINGS

FIG. 1 is a connection diagram showing one example in which the present invention is applied to a self-light-emitting display module using a passive-drive type display panel;

FIG. 2 is a connection diagram showing one example of a concrete circuit configuration for a current/voltage converter in FIG. 1;

FIG. 3 is a connection diagram showing one example of a concrete circuit configuration for an analog-digital converter and a control circuit in FIG. 1;

FIG. 4 is a flow chart explaining a first operation example of a malfunction detection unit according to a configuration shown in FIGs. 1 to 3;

FIG. 5 is a drawing of wave forms of currents used for determining whether a defect is caused in a pixel;

FIG. 6 is a f low chart explaining a second operation example of the malfunction detection unit according to the configuration shown in FIGs. 1 to 3; and

FIG. 7 is a connection diagram showing one example in which the present invention is applied to a self-light-emitting display module using an active-drive type display panel.

DESCRIPTION OF THE PREFERRED EMBODIMENTS

Hereinafter, a self-light-emitting display module according to the present invention will be explained, referring to embodiments shown in drawings. Here, the self-light-emitting display module according to the invention comprises a light-emitting display panel on which a lot of self-light-emitting elements with an electric polarity are arranged in a matrix manner, and a drive device for lighting drive of each self-light-emitting element on the light-emitting display panel. The drive device further comprises a malfunction detection unit by which malfunction in light emitting of a light-emitting display panel is detected. And, an example in which an organic EL element using an organic material for the light-emitting layer is adopted as a self-light-emitting element is shown in an embodiment which will be hereinafter explained.

The organic EL element can be replaced by a configuration comprising a light-emitting element with an electric polarity (diode characteristic) and a parasitic capacitance component which is connected to the light-emitting element in parallel, and the organic EL element can be called as a capacitive light-emitting element. In the organic EL element, charges corresponding to the electric capacity of the element concerned flow into an electrode as a displacement current, in the first place, for accumulation, when a light-emitting drive voltage is applied in the forward direction. Subsequently, a current starts to flow from one electrode (the anode side of the diode element) to an organic layer forming the light-emitting layer when a predetermined voltage (light-emitting threshold voltage = Vth) inherent in the element concerned is exceeded, and light is emitted with a strength proportional to the current, according to one consideration.

On the other hand, since the organic EL element has a current and brightness characteristic stable to changes in the temperature and a voltage and brightness characteristic unstable to changes in the temperature, and is much deteriorated to shorten the light-emitting life when an overcurrent is applied, it is general to drive the EL element by a constant current. A passive-matrix type display panel in which the EL elements are arranged in a matrix manner, and an active-matrix type display panel in which lighting drive of each EL element arranged in a matrix manner is independently executed, using a TFT (Thin Film Transistor), have been proposed as a display panel using such an organic EL element.

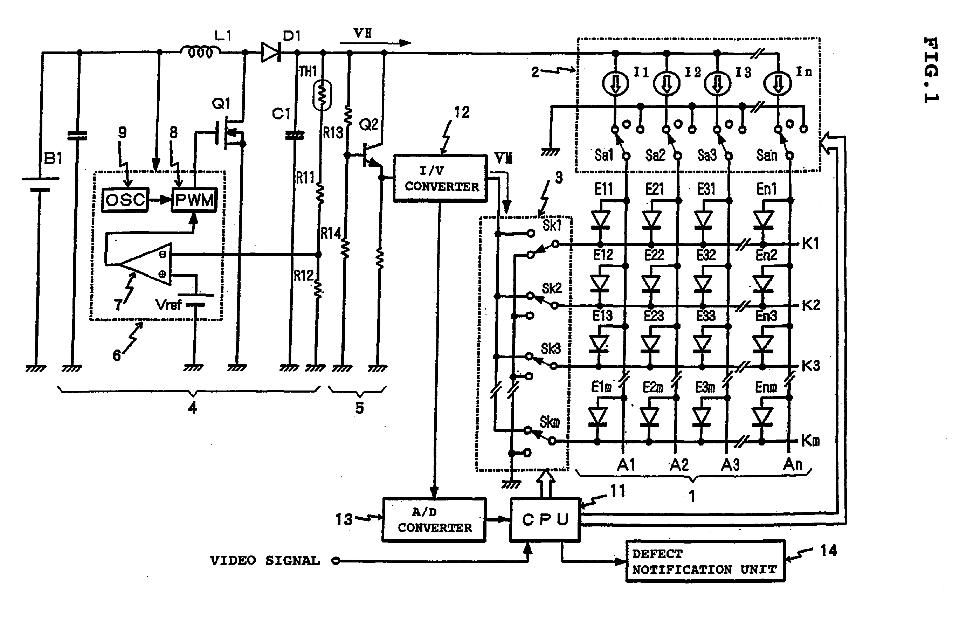

FIG. 1 shows the self-light-emitting display module including the passive-matrix type display panel. There are two methods, that is, a cathode-line scanning and anode-line drive method and an anode-line scanning and cathode-line drive method, as a method for driving the organic EL element in the passive-matrix type drive system. A configuration shown in FIG. 1 indicates a form of the former method, that is, the cathode-line scanning and anode-line drive method. Specifically, a display panel 1 has a configuration in which anode lines A1 through An as n number of drive lines are arranged in the vertical direction (like columns); cathode lines K1 through Km as m number of scanning lines are arranged in the horizontal direction (like rows); and organic EL elements E11 through Enm, which are shown with a diode symbol, are arranged at intersections (n $\times$ m points in total) of the anode and cathode lines, respectively.

In correspondence to the position of each intersecting point of the anode lines A1 through An along the vertical direction and the cathode lines K1 through Km along the horizontal direction, one end (an anode terminal in an equivalent diode of an EL element) is connected to one anode line, and another end (a cathode terminal in the equivalent diode of the EL element) is connected to one cathode line with regard to each EL element E11 through Enm forming a pixel. Moreover, each of the anode lines A1 through An is connected to an anode-line drive circuit 2 as a data driver forming a lighting drive device, and, similarly, each of the cathode lines K1 through Km is connected to a cathode-line scanning circuit 3 as a scanning driver forming the lighting drive device to drive the anode and cathode lines, respectively.

The above-described anode-line drive circuit 2 comprises constant current sources I1 through In and, drive switches Sa1 through San, which are operated by using a driving voltage VH applied from a step-up circuit 4 in the after-described DC-DC converter, and the drive switches Sa1 through San has a function by which, when the switches are connected to the sides of the above-described constant current sources I1 through In, currents from the constant current sources I1 through In are supplied to individual EL elements E11 through Enm arranged corresponding to the cathode lines, respectively. Moreover, the present embodiment has a configuration in which, when currents from the constant current sources I1 through In are not supplied to the individual EL elements, each of the above-described anode lines are connected to an open terminal (the high impedance side), or to the ground as a reference potential point according to the above-described drive switches Sa1 through San.

Furthermore, the above-described cathode-line scanning circuit 3 is provided with scanning switches Sk1 through Skm corresponding to each of the cathode lines K1 through Km in a respective manner. The switches have a function by which either of a reverse bias voltage VM from the after-described circuit for generating a reverse bias voltage 5 to prevent crosstalk light-emitting, or a ground potential as a reference potential point is supplied to the corresponding cathode lines. Thereby, light-emitting of each of the above-described EL elements is selectively executed by connecting the constant current sources I1 through In to desired the anode lines A1 through An while setting the cathode lines at the reference potential point (the ground potential) with a predetermined cycle.

On the other hand, the above-described DC-DC converter has a configuration, in the example shown in FIG. 1, in which the direct-current driving voltage VH is generated, using PWM (pulse width modulation) control in the step-up circuit 4. Here, the above DC-DC converter may use well-known PFM (pulse frequency modulation) control or PSM (pulse skip modulation) control, in stead of the PWM control.

The DC-DC converter has a configuration in which on-control of a power MOS FET (metal oxide semiconductor field-effect transistor) Q1 as a switching element is executed with a predetermined duty cycle by PWM waves output from a switching regulator 6 forming a part of the step-up circuit 4. That is, electric power energy from a DC voltage source B1 on the primary side is accumulated in an inductor L1 by the on-operation of the power FET Q1, and the electric power energy which has been accumulated in the above-described in the inductor L1 is accumulated in a capacitor C1 through a diode D1 by off operation of the power FET Q1. Then, step-upped DC output can be obtained as a terminal voltage of the capacitor C1 by repeating the on-off operation of the above-described power FET Q1.

The above-described DC output voltage is divided by a thermistor TH1 for temperature compensation, and resistors R11, R12, and supplied to an error amplifier 7 in a switching regulator 6 for comparison with a reference voltage Vref in a error amplif ier 7. The comparison output (error output) is supplied to a PWM circuit 8, and feedback control of the above-described output voltage is executed by controlling the duty cycle of signal waves from an oscillator 9 so that a predetermined driving voltage VH is kept. Accordingly, the output voltage from the DC-DC converter, that is, the above-described driving voltage VH can be expressed by the following formula 1.

$$VH = Vref \times [(TH1 + R11 + R12)/R12] \qquad \text{(FORMULA 1)}$$

On the other hand, the above-described circuit for generating a reverse bias voltage 5 used for preventing crosstalk light-emitting comprises a voltage dividing circuit for dividing the above-described driving voltage VH. That is, the voltage dividing circuit comprising resistors R13, R14, and an npn transistor Q2 functioning as an emitter-follower has a configuration by which the reverse bias voltage VM is obtained in an emitter of the above-described transistor Q2. Therefore, when a voltage between a base and the emitter in the above-described transistor Q2 is indicated by Vbe, the reverse bias voltage VM obtained by the voltage dividing circuit can be expressed by the following formula 2.

$$VM = VH \times [R14/(R13 + R14)] - Vbe \qquad \text{(FORMULA 2)}$$

Here, a control bus from a control circuit 11, including CPU (central processing unit), provided with a light-emitting control function and the after-described malfunction detection function is connected to the above-described anode-line circuit 2 and the above-described cathode-line scanning circuit 3. Then, the above-described scanning switches Sk1 through Skm and the drive switches Sa1 through San are operated, based on a video signal to be displayed. Thereby, based on the video signal, the constant current sources I1 through In are connected to a desired anode line while setting the cathode scanning lines at the ground potential with a predetermined cycle. Accordingly, light emitting of each of the above-described light-emitting elements is selectively executed, and an image based on the above-described video signal is displayed on the display panel 1.

Here, in a state shown in FIG. 1, the first cathode line K1 is set at the ground potential to be in a scanning state. At this time, the reverse bias voltage VM is applied from the above-described circuit for generating a reverse bias voltage 5 to the cathode lines K2 through Km in a non-scanning state. According to the above configuration, crosstalk light-emitting of each EL element connected to an intersecting point of an anode line, which is driven, and a cathode line, which is selected for scanning, is prevented.

On the other hand, a current/voltage (I/V) converter 12 is arranged between the above-described circuit for generating a reverse bias voltage 5 and the above-described cathode-line scanning circuit 3 in the embodiment shown in FIG. 1. An analog voltage obtained by the current/voltage converter 12 is configured to be converted into a piece of digital data by an analog-digital (A/D) converter 13 to be supplied to the above-described control circuit 11 including CPU. In the present embodiment, the above components of the current/voltage converter 12, the analog-digital converter 13, and the control circuit 11 are included in the malfunction detection unit by which malfunction in light emitting caused by defects in the light-emitting display panel 1, the lighting drive device including the anode-line drive circuit 2 and the cathode-line scanning circuit 3, or a connecting portion between the above-described light-emitting display panel and the above-described lighting drive device is detected. Moreover, in the present embodiment, the above-described control circuit 11 has a configuration in which, when a defect is detected, for example, in a pixel of the display panel, a defect notification unit (storage notification unit) 14 is operated according to the detection.

A method for verifying a defect state according to the present invention, and, more particularly, a method for verifying a defect of a pixel on the display panel will be explained in detail. In the configuration shown in FIG. 1, a current passes through each EL element E11 through Enm in a non-light-emitting direction, using the reverse bias voltage VM from the circuit for generating a reverse bias voltage 5, and, based on a wave form of the passed current at this time, the presence of a defect in the light-emitting display panel 1, the lighting drive device including the anode-line drive circuit 2 and the cathode-line scanning circuit 3, or the like is verified. In order to realize the above verification, the current/voltage converter 12 is arranged between the circuit for generating a reverse bias voltage 5 and the cathode-line scanning circuit 3 as described above.

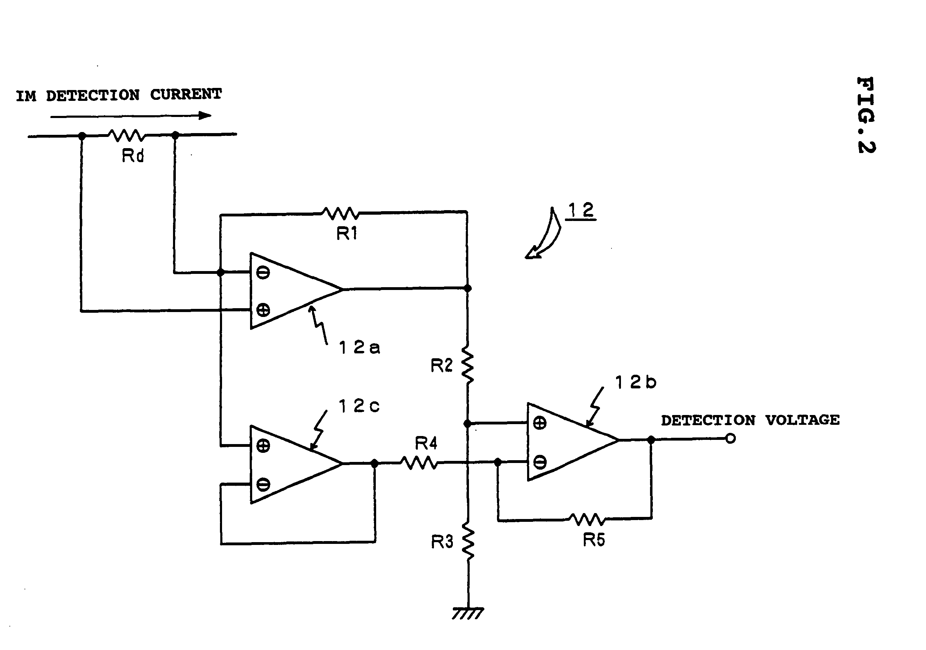

FIG. 2 shows one example of a concrete circuit configuration for the above-described current/voltage converter 12. As shown in FIG. 2, a dropper resistance Rd is included in order to detect a current value IM passing from the circuit for generating a reverse bias voltage 5 to the side of the cathode-line scanning circuit 3. The side of the cathode-line scanning circuit 3 in the above-described dropper resistance Rd is connected to the noninverting input terminal of an operational amplifier 12a, and the side of the circuit for generating a reverse bias voltage 5 in the resistance Rd is connected to the inverting input terminal of the operational amplifier 12a. Moreover, a feedback resistance R1 is connected between the output terminal and the inverting input terminal of the operational amplifier 12a. Accordingly, the operational amplifier 12a functions as a voltage amplifier, and an output corresponding to the voltage across the above-described resistance Rd is generated at the output terminal of the amplifier 12a.

The output of the above-described operational amplifier 12a is configured to be supplied to the noninverting input terminal of an operational amplifier 12b after division by the resistances R2, R3. On the other hand, the potential at the noninverting input terminal of the above-described operational amplifier 12a is configured to be supplied to the noninverting input terminal of an operational amplifier 12c. The output terminal of the operational amplifier 12c is connected to the inverting input terminal of the amplifier 12c for function of the amplifier 12c as a buffer amplifier. Moreover, the output terminal of the operational amplifier 12c is connected to the noninverting input terminal of the amplifier 12b through a resistance R4.

Similarly, a feedback resistance R5 is connected between the output terminal and the inverting input terminal of the above-described operational amplifier 12b. Accordingly, the operational amplifier 12b functions as a voltage amplifier, and, as a result, an output corresponding to the voltage across the above-described resistance Rd is obtained as a detection voltage at the output terminal of the operational amplifier 12b.

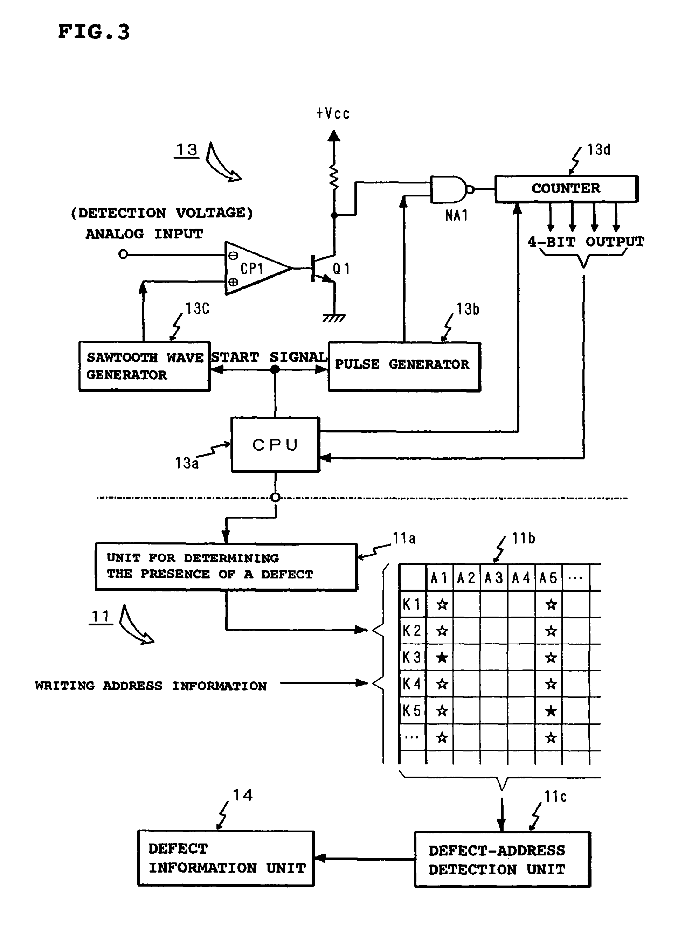

The upper part in FIG. 3 shows one example of a concrete circuit configuration for the analog-digital converter 13 by which a detection voltage from the above-described current/voltage converter 12 is converted into a piece of digital data. The detection voltage from the above-described current/voltage converter 12 is supplied to the inverting input terminal of a comparator CP1 shown in FIG. 3. Similarly, CPU 13a is provided in the analog-digital converter 13 shown in FIG. 3. According to the configuration of the converter 13, a start signal is supplied from CPU 13a to a pulse generator 13b and a sawtooth wave generator 13c, and, at the same time, a counter-resetting signal is supplied from CPU 13a to a counter 13d, simultaneously with the start signal.

Thereby, a counter value in the counter 13d is reset in the first place. Subsequently, a count up output is supplied from a NAND gate NA1 to the counter 13d, based on a pulse output from the pulse generator 13b. Then, the counter 13d starts a count up operation.

On the other hand, a sawtooth wave is supplied from the sawtooth wave generator 13c to the non-inverting input terminal of the comparator CP1. The above-described comparator CP1 executes switching of a transistor Q1 when the level of an analog input (detection voltage) and that of a sawtooth wave from the sawtooth wave generator 73 intersect. Thereby, the pulse generator 13b stops outputting of a pulse through the NAND gate NA1 and the counter 13d stops the count up operation.

That is, the counter 13d has a function in which a counted value corresponding to the time between a point, at which counting is started when the start signal is supplied from CPU 13a, and a point, at which the level of the analog signal supplied to the comparator CP1 and that of the above-described sawtooth wave intersect, is supplied to CPU 13a as an output of several bits (output of four bits in the example shown in FIG. 3) . Thereby, the detection voltage acquired by the current/voltage converter 12 is taken into CPU 13a as digital data for a while, and, then, is supplied to the control circuit 11 with the above-described malfunction detection function.

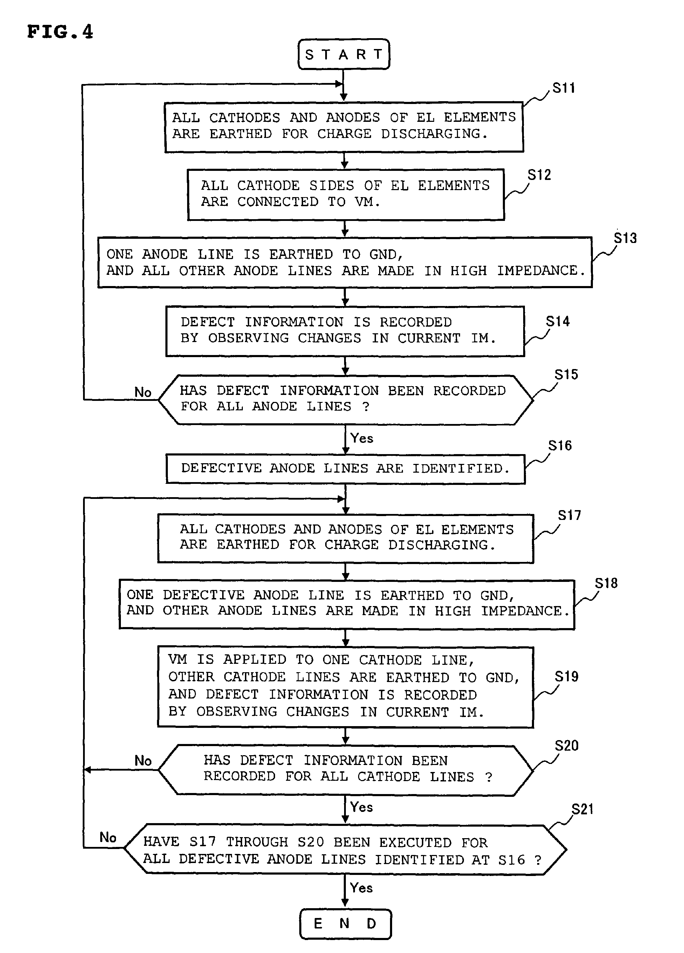

Then, an operation in the malfunction detection unit by which malfunction in light emitting of the self-light-emitting display module is detected according to the configuration shown in FIGs. 1 to 3 will be explained, referring to a flow chart shown in FIG. 4. Preferably, operation of the malfunction detection unit shown in FIG. 4 is started when, for example, operating power is supplied to the self-light-emitting display module comprising the above-described light-emitting display panel, and the lighting drive device; the operation is started on a regular basis under a state in which the operating power is supplied; or the operation is started when ON-operation of a detecting switch is executed by a user.

A step S11 shown in FIG. 4 is to execute an operation by which the cathodes and the anodes of all the EL elements are earthed, and charges accumulated as the parasitic capacitance of the EL elements are discharged. The operation is realized by connecting all the scanning switches Sk1 through Skm in the cathode-line scanning circuit 3 shown in FIG. 1 to the ground GND, and all the drive switches Sa1 through San in the anode-line drive circuit 2 shown in FIG. 1 to the ground GND. Then, the cathode sides of all the EL elements are connected to the reverse bias voltage VM at a step S12. This operation is realized by connecting all the scanning switches Sk1 through Skm in the cathode-line scanning circuit 3 to the side of the circuit for generating a reverse bias voltage 5 under a state in which all the drive switches Sa1 through San are set to the open terminals (the sides of high impedance), respectively.

Subsequently, one of the anode lines is earthed to the ground GND at STEEP S13, and all of the other anode lines are put into a high impedance state. That is, for example, the anode line A1 which is the first line from the left is earthed by the drive switch Sa1 in the anode-line drive circuit 2, and the drive switches Sa2 through San corresponding to the other anode lines A2 through An which are the second line and the subsequent lines from the left are set to the corresponding open terminals (the high-impedance sides), respectively.

Then, the presence of a defect corresponding to one anode line and the state of the defect if any are determined by observing changes in the current IM passing in the non-light-emitting direction, and an operation to record the determined information is executed at a step S14. The operation at the step 14 is executed by a unit 11a for determining the presence of a defect which is provided in the control circuit 11 shown in FIG. 3. That is, in the unit 11a for determining the presence of a defect, a piece of data supplied from the analog-digital converter 13 which has been already explained is obtained to determine whether there is a defect in the anode line A1 which is the first line, or a pixel connected to the anode line A1.

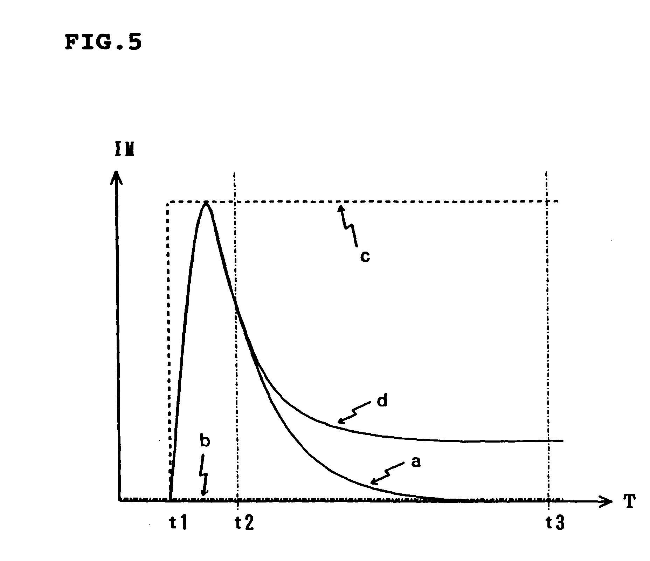

FIG. 5 explains the determination method, and shows changes in a current when, under a state in which charges accumulated as the parasitic capacitance of an EL element are discharged, the current is supplied to the EL element in the non-light-emitting direction of the EL element. Here, the current IM rapidly rises and the current IM becomes about zero after a predetermined time has passed because an charging operation is executed for the EL element as the parasitic capacitance when a path between the cathode-line scanning circuit 3 to each pixel connected to the anode line A1 and a path from the anode line A1 to the anode-line drive circuit 2 are normal. That is, a characteristic curve a, which is shown in FIG. 5, is obtained.

On the other hand, the value of the current VM is zero with no change as shown in a dotted and dashed line when a part of the above-described paths, especially, the anode line has been broken. That is, a characteristic curve b, which is shown in FIG. 5, is obtained. Moreover, the value of the current IM keeps a large one as shown in a dashed line when a part of the above-described paths, especially, the anode line or an EL element has been in a completely short-circuited state. That is, a characteristic curve c, which is shown in FIG. 5, is obtained. Furthermore, the current value does not return to zero after the current IM rapidly rises, and a characteristic curve d which is shown in FIG. 5 is obtained when a part of the above-described paths, especially, the anode line or an EL element has been in a state in which there is an incompletely shorted point.

Accordingly, it is possible to identify whether a characteristic curve is a normal one shown by a curve a in FIG. 5, or a defective one shown by curves b through d by detecting the value of the current IM at a time t2 after a first predetermined time has passed from the starting point, and, further, by detecting the value of the current IM at a time t3 again after a second predetermined time has passed from the starting point when a time t1 is a starting time as shown in FIG. 5. In this case, defect patterns shown in the curves b through d can be identified. Though the characteristic curves shown in FIG. 5 are indicated as analog data here for convenience of explanation, the above-described unit 11a for determining the presence of a defect which is shown in FIG. 3 executes the similar determination operation, using digital data.

Here, when it is determined by the above-described unit 11a for determining the presence of a defect that there is a defect, that is, when it is decided that a characteristic curve is, for example, of one of the curves b through d of a defective pattern, other than the curve a shown in FIG. 5, an operation is executed to set a flag in a storage unit 11b formed in a two-dimensional map. In this case, the control circuit 11 understands at verification what anode line has been determined to be defective. Accordingly, an operation is executed as one example to write all flags (asterisks in the storage unit 11b shown in FIG. 3) in a column showing an anode line A1 in an exemplary view showing the storage unit 11b, using written address information at this time. Thereby, it is stored that the path corresponding to the anode line A1 is defective.

Returning to FIG. 4, it is determined at a step S15 whether the above-described steps S11 through S14 have been executed for all the anode lines. That is, the above-described steps S11 through S14 are executed for each anode line as a routine, and an operation is executed to set a flag in the storage unit 11b when a defect corresponding to the anode line concerned is included. Here, it is indicated in the storage unit 11b shown in FIG. 3 that there is a defect in any part of a path through an anode line A5, other than the defect on the path through the above-described anode line A1.

Then, an anode line with a defect is identified at a step S16 by referring to the storage unit 11b. Subsequently, at a step S17, the cathodes and the anodes of all the EL elements are earthed, and charges accumulated as the parasitic capacitance of the EL elements are discharged. The above operation is a similar one to that of the step S11 which has already been explained. Then, the processing proceeds to a step S18 at which one of the defective anode lines which have been identified at the above-described step S16 is earthed to the ground GND to put the other anode lines into a high impedance state. The above operation is realized by earthing the defective anode line A1 to the ground by the drive switch Sa1 in the first place, and, then, by setting each of the drive switches Sa2 through San, which is corresponding to the other anode lines A2 through An, to the open terminals (the sides of high impedance), respectively.

Subsequently, at a step S19, the voltage VM is applied to one of the cathode lines, the other cathode lines are earthed, and an operation is executed to record defect information by observing changes in the current IM. In this case, the scanning switch Sk1 corresponding to a first cathode line K1 is connected to the reverse bias voltage VM side, and the scanning switches Sk2 through Skm corresponding to the other cathode lines K2 through Km is connected to the ground. Thereby, a current is supplied to the first EL element E11 connected to the defective anode line A1 in the non-light-emitting direction. It is determined by a wave form of the current at this time whether the EL element E11 is normal or not.

A determination technique at this time is similar to that of the example which has been explained at the step S14, and is executed, based on wave forms of currents, which are shown in FIG. 5. Then, when it is determined that the EL element E11 is normal, an operation is executed to clear the flag corresponding to an intersecting coordinate of the anode line A1 and the cathode line K1 in the storage unit 11b. This operation is executed by the above-described unit 11a for determining the presence of a defect.

Subsequently, the processing proceeds to a step S20 at which it is determined whether defect information has been recorded for all the cathode lines or not. That is, the above-described steps S17 through S19 are executed for each cathode line as a routine, and it is individually determined for each of the other EL elements E12 through Elm at the corresponding anode line A1 whether each of them is normal or not. Then, when it is determined that an element is normal, an operation is executed in a similar manner to the above-described cases to clear a flag at the corresponding intersecting coordinate, and, when it is determined that an element is in a defect state, the corresponding flag is not cleared to be left. Here, it is found in the storage unit 11b shown as an exemplary view in FIG. 3 that there is a defect in the EL element E13 corresponding to the intersecting coordinate of the anode line A1 and the cathode line K3.

Then, the processing proceeds to a step S21 at which it is determined whether the steps S17 through S20 have been executed for all the anode lines which have been identified to be defective. In other word, the verification is similarly executed for the above-described anode line A5 with a defect to stop the operation by the malfunction detection unit. In this case, it is also found in the storage unit 11b shown as an exemplary view in FIG. 3 that there is a defect in an EL element corresponding to an intersecting coordinate of the anode line A5 and the cathode line K5. Here, there may be operations at the above-described step S19, that is, one of the cathode lines is earthed to the ground GND; the voltage VM is applied to the other cathode lines; and defect information is recorded by observing changes in the current IM.

According to the operation of the malfunction detection unit which has been explained above, malfunctions in light-emitting of all the pixels using the EL elements formed on the display panel can be detected. Moreover, the coordinate of a pixel with a malfunction in the light-emitting can be detected by the address of the corresponding flag written in the storage unit 11b shown in FIG. 3. Then, a defect-address detection unit 11c shown in FIG. 3 activates the defect notification unit 14, based on the address of a flag written in the storage unit 11b.

In this case, the processing can be continued without activating the defect notification unit 14 when a defect is caused at a position with less possibility that there is caused erroneous display of a wrong number even if there is caused the defect in a pixel. Furthermore, when a defect in a pixel is located, for example, at a position which displays a decimal point, it is required to activate the defect notification unit 14, even if a number of defective pixels is small. Preferably, the activation of the unit depends on a device provided with the self-light-emitting display module.

In the above-described defect notification unit 14, a unit in which notification is executed in an auditory manner similar to that of, for example, a buzzer may be adopted, or there may be displayed a message notifying that a failure is generated on the display panel 1. Alternatively, the unit 14 can be realized by a method in which it is clearly shown by turning off the display of the display panel 1 that there is a failure. In this case, it may be also considered that a unit to change a display position in a proper manner is adopted. The unit may be used, for example, for a meter used for an aircraft in which it is not allowed to turn off the display.

Though a defective pixel is identified by observing a change in the current IM to store the corresponding coordinate as shown in FIG. 5 in the above-described embodiment, there may be used, in this case, a configuration in which defective patterns shown by the curves b, c, d in FIG. 5 are also stored in a simultaneous manner, for example, with data of about two bits, and it is determined whether the above-described defect notification unit 14 is activated or not according to the defective patterns and defect positions.

Though it is configured in the above-described explanation mainly to be verified whether there is a defect in each pixel arranged on the display panel 1, it is difficult to assume that there are caused defects in individual pixels on all the anode lines when a determination result that all the anode lines are defective is obtained at the step S16 shown in FIG. 4. In this case, it is possible to assume, according to the defect patterns b, c, d shown in FIG. 5, that there is caused a broken or short-circuit state on the path including the cathode-line scanning circuit 3, the anode-line drive circuit 2, and connecting portions among them, except pixels arranged on the display panel 1. Based on the assumption, a state of a defect can be notified to a user by driving the above-described defect notification unit 14.

Moreover, even when anode lines including a defect are identified at the step S16 shown in FIG. 4, the steps S17 through S20 shown in FIG. 4 are executed for the identified anode lines, and any one of the defect patterns b, c, d shown in FIG. 5 is found for all the defective anode lines, it is difficult to assume that there is a defect in each of all the anode lines which has been identified to be defective. In this case, it is possible to assume according to each of the defect patterns b, c, d shown in FIG. 5 that there is caused a broken or short-circuit state on the path including the cathode-line scanning circuit 3, the anode-line drive circuit 2, and the connecting portions among them, except the pixels arranged on the display panel 1. Based on the above assumption, the states of defects can be notified to a user by driving the above-described defect notification unit 14 in a similar manner to that of the previous case.

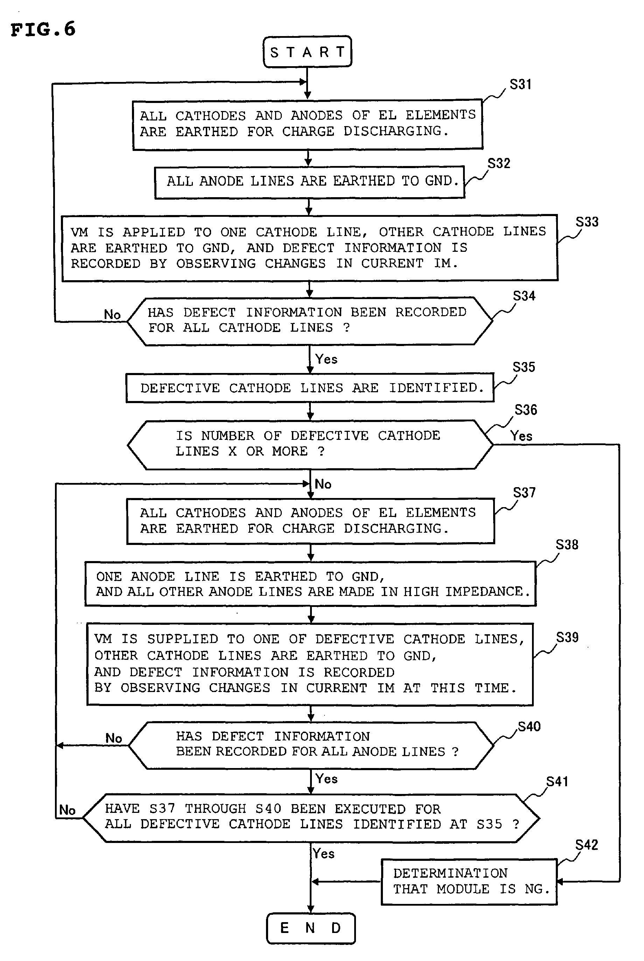

The above-described operation flow shown in FIG. 4 has a configuration in which the presence of a defect is sequentially verified for the anode lines in the first place, and, in the second place, it is individually verified for the anode lines with a defect whether pixels connected to the anode lines concerned and the cathode lines connected to the pixels are defective or not. On the other hand, an operation flow which is shown in FIG. 6 and will be explained hereinafter has a configuration in which the presence of a defect is sequentially verified for the cathode lines in the first place, and, in the second place, it is individually verified for the cathode lines with a defect whether pixels connected to the cathode lines concerned and the anode lines connected to the pixels are defective or not.

Steps S31 through S34 shown in FIG. 6 are for verification operation corresponding to steps S17 through S20, and at the steps operations for verifying the presence of a defect in a sequential manner are executed for the cathode lines. At the step S31, the cathodes and the anodes of all the EL elements are earthed, and charges accumulated as the parasitic capacitance of the EL elements are discharged. The above step is a similar operation to those of the steps S11, S17 which have been already explained, based on FIG. 4. Subsequently, all of the anode lines are earthed to the ground GND as one operation at the step S32. The above operation is realized by switching all of the drive switches Sa1 through San shown in FIG. 1 to the ground side.

Then, at the step S33, the reverse bias voltage VM is applied to one cathode line, and the other cathode lines are earthed to the ground. Then, an operation is executed to record defect information by observing changes in the current IM. In this case, the scanning switch Sk1 corresponding to the first cathode line K1 is connected to the reverse bias voltage VM side, and the scanning switches Sk2 through Skm corresponding to the other cathode lines K2 through Km are connected to the ground. Thereby, the presence of a defect is verified for the first cathode line K1, and the result is recorded in the storage unit 11b shown in FIG. 3. The determination technique at this time is executed, based the current forms as shown in FIG. 5, in a similar manner to that of the step S19 which is shown in FIG. 4 and has been already explained.

Then, it is determined at the step S34 whether defect information has been recorded for all the cathode lines. That is, the above-described steps S31 through S33 are executed as a routine for each cathode line. Subsequently, a cathode line having a defect is identified at a step S35. In the operation flow shown in FIG. 6, it is determined, as shown in a step S36, whether there are more than a number x of the cathode lines having a defect, immediately after the cathode lines having a defect is identified at the step S35.

Here, in the case of Yes, that is, when it is determined that there are a number x of the cathode lines having a defect, though there are a number m of the cathode lines as described above, and when the ratio (x/m) is considerably large, it can be considered that there is caused a large defect in the whole module including the display panel 1. Preferably, it is immediately determined as shown at a step S42 that a module is in a no-good (NG) state, and a piece of information, for example, by which use of the device provided with the display module concerned is stopped, is notified by the above-described defect notification unit 14. As described above, there is a case in which it is more quickly understood by verifying the presence of a defect for the cathode lines in the first place that the display module is in a no-good state.

On the other hand, when it is determined at the step S36 that the number of the cathode lines having a defect is less than a number x, the processing proceeds to a step S37. Here, at the steps S37 through S40, it is individually verified for the cathode lines which have been identified at the step S35 to be defective whether pixels connected to the cathode lines concerned and the anode lines connected to the pixels are defective or not. Here, at the step S37, the cathodes and the anodes of all the EL elements are earthed, and charges accumulated as the parasitic capacitance of the EL elements are discharged. The above step is a similar operation to that of the step S31 which has been already explained.

Then, the processing proceeds to a step S38 at which one of the anode lines, for example, the anode line A1 is earthed to the ground, and the other anode lines are put into a high impedance state. The above step is realized by the drive switches Sa1 through San. Subsequently, the processing proceeds to a step S39 at which the voltage VM is applied to one of the cathode lines which have been identified at the above-described step S35 to be defective, and the other cathode lines is earthed to the ground GND. The above step is realized by the scanning switches Sk1 through Skm. Then, an operation is executed to record defect information by observing changes in the current IM passing in the non-light-emitting direction. The determination technique at this time is a similar one to that of the step S14 which is shown in FIG. 4 and has been already explained.

Subsequently, it is determined at the step S40 whether defect information has been recorded or not for all the anode lines. That is, the above-described steps S37 through S39 are executed as a routine for each anode line. Then, it is determined at the step S 41 whether the steps S37 through S40 have been executed or not for all the cathode lines which have been identified at the step S35 to be defective, and the verification operations are completed.

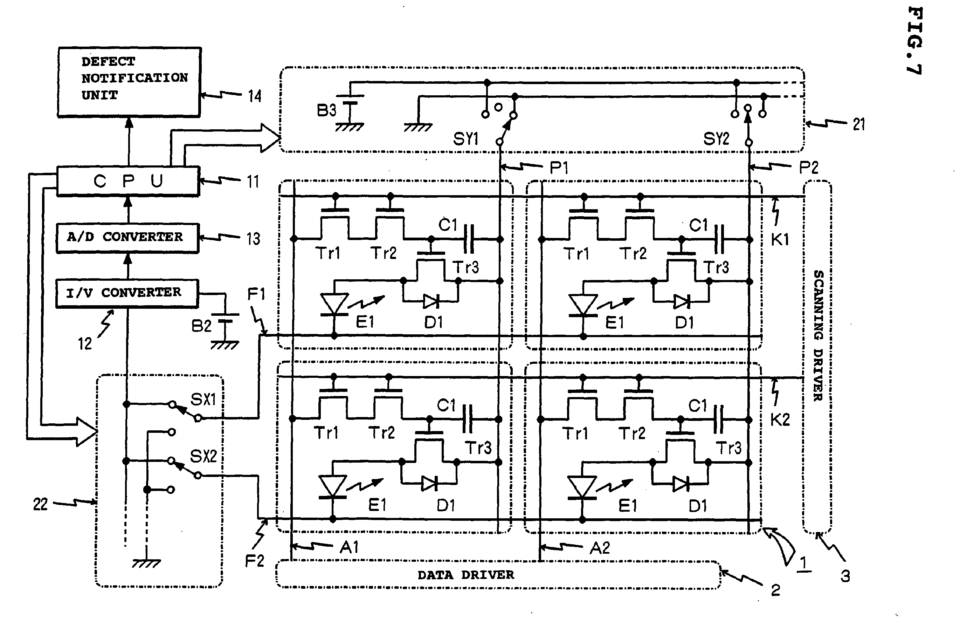

The embodiment which has been explained above shows an example in which the present invention is applied to the self-light-emitting display module using the passive-matrix type display panel. But, the invention can be applied to a self-light-emitting display module using the active matrix type display panel. FIG. 7 shows an example in which the present invention is applied to the self-light-emitting display module using the active-matrix type display panel. Parts corresponding to those previously explained are denoted by the same reference numbers as those in the previous embodiment. And, individual explanation in detail will be eliminated for those parts.

A number of data electrode lines A1, A2, ..... by which data signals corresponding to video data from a data driver 2 are respectively supplied are arranged like columns on a display panel 1 according to an embodiment shown in FIG. 7, and a number of power supply lines P1, P2, ..... are arranged parallel to the above-described data electrode lines. On the other hand, a number of scanning electrode lines K1, K2, ..... by which scanning signals are supplied from a scanning driver 3 are arranged like rows, and a number of power control lines F1, F2, ..... are arranged parallel to the above-described scanning electrode lines.

And, a circuit configuration including each EL element E1 corresponding to a unit light-emitting pixel comprises TFTs for control, TFTs for driving, and capacitors. Here, according to the configuration shown in FIG. 7, first and second transistors Tr1, Tr2 are used as TFT for control, and scanning signals for scanning row lines are sequentially given to each gate of the above transistors through scanning electrode lines K1, K2, ......

Moreover, each source and each drain of the first and the second transistors Tr1, Tr2 for control are connected to each other in series in the present embodiment. And, each source of the first transistors Tr1 for control is connected to the data electrode lines A1, A2, ....., and each drain of the second transistors Tr2 for control is connected to each gate of transistors Tr3 for driving and, at the same time, to one terminal of each capacitor C1.

The other terminal of each of the above-described capacitors C1 and each source of the transistors Tr3 for driving are connected to the power supply line P1, P2, .....; and each drain of the transistors Tr3 for driving is connected to each of the anode terminals of the EL elements E1. Furthermore, each of the cathode terminals of the EL elements E1 is connected to power supply control lines F1, F2, ...... Moreover, a diode D1 is connected between each drain and each source of the transistors Tr3 for driving in the present embodiment. The diodes are conducting, and used for bypassing the transistors Tr3 for driving when the malfunction detection unit is activated as described later and a current passes through each EL element E1 in the non-light-emitting direction. Here, four pixels are shown in the configuration in FIG. 7, considering the limited space, but the configuration which has been explained above can be applied in a similar manner to a configuration including more than four organic EL elements arranged on the display panel 1.

In a light-emitting control operation for a unit pixel on the display panel 1 in which a plurality of the above-descried circuits are arranged like rows and columns, an ON-state voltage is supplied during an address period to each gate of a first and a second transistors Tr1, Tr2 for control through the scanning electrode lines K1, K2, ..... Thereby, a current corresponding to video data signals supplied through each source and each drain of the transistors Tr1 and Tr2 which are connected to each other in series and through the data electrode lines A1, A2, ..... is passed in the capacitor C1 for charging the capacitors C1. Then, each charge voltage is supplied to each gate of the transistors Tr3 for driving, and currents corresponding to gate voltages and control voltages (the ground voltage in the present embodiment) which are supplied to the power control lines F1, F2, ..... are passed in the organic EL elements E1 by the transistors Tr3 for light-emitting of the EL elements E1.

On the other hand, when the gate voltages of the transistors Tr1, Tr2 for control becomes an OFF-state voltage, the transistors Tr1, Tr2 become in a so-called cut-off state. However, the gate voltages of the transistors Tr3 for driving are maintained by charges accumulated in the capacitors C1. Then, driving currents to the organic EL elements E1 by the transistors Tr3 for driving are maintained till the next addressing, and light-emitting of the EL elements E1 is maintained.

In the configuration shown in FIG. 7, in addition to the self-light-emitting display module including the light-emitting display panel 1, the data driver 2, and the scanning driver 3, the malfunction detection unit for detecting a defect in light emitting of the self-light-emitting display module is further provided. That is, the malfunction detection unit comprises: a control circuit 11 including CPU; a current/voltage converter 12; an analog-digital converter 13; a power supply block 21; and a non-light-emitting current supply block 22. Moreover, a defect notification unit 14 is configured to be operated by an instruction from the control circuit 11.

When the display panel 1 is in a lighting drive state, a driving voltage from a power supply B3 is supplied by the above-described power supply block 21 to the power supply lines P1, P2, ..... through switches SY1, SY2, ..... At this time, switches SX1, SX2, ..... in the non-light-emitting current supply block 22 are connected to the ground side. Thereby, light-emitting of each pixel arranged on the display panel 1 is selectively executed as described above.

Here, when, for example, a defect in a pixel on the display panel is verified by the above-described malfunction detection unit, a current is supplied, as already explained above, to each EL element E1 in the non-light-emitting direction. In order to realize the above operation, switches SX1, SX2, ..... in the non-light-emitting current supply block 22 are connected to the side of the current/voltage converter 12 by an instruction from the control circuit 11 including CPU. Moreover, in a state shown in FIG. 7, the switch SY1 in the power supply block 21 is connected to the ground by the control circuit 11, and the other switches are set to open terminals (the sides of high impedance), respectively.

Thereby, the current from a voltage source B2 passes on a path through the current/voltage converter 12, the switches SX1, SX2, ..... in the non-light-emitting current supply block 22, the power supply control lines F1, F2, ....., the EL elements E1, the power supply lines P1, P2, ....., and the switch SY1 in the power supply block 21. Voltage conversion of the current at this time is executed by the current/voltage converter 12. Subsequently, the current is converted into digital data by the analog-digital converter 13 and supplied to the control circuit 11.

As is evident in the above-described explanation, when, for example, a defect of a pixel on the display panel is verified by the malfunction function, the switches SX1, SX2, ..... in the non-light-emitting current supply block 22 are operated in a similar manner to that of scanning switches Sk1 through Skm in a cathode-line scanning circuit 3 shown in FIG. 1. Moreover, the switches SY1, SY2, .... in the power supply block 21 are operated in a similar manner to that of drive switches Sa1 through San in an anode-line drive circuit 2 shown in FIG. 1. Accordingly, the operation flows, which are shown in FIG. 4 and FIG. 6 which have already been explained, of the malfunction detection unit can be executed by the circuit configuration shown in FIG. 7.

**Claims**

1. A self-light-emitting module comprising a light-emitting display panel in which a number of pixels using a self-light-emitting element with an electric polarity are arranged in a matrix manner, and a lighting drive device for selective lighting drive of the self-light-emitting elements on the light-emitting display panel, wherein

   a malfunction detection unit, bywhichmalfunction in light emitting caused by defects in the light-emitting display panel, the lighting drive device, or a connecting portion between the light-emitting display panel and the lighting drive device is detected, is further provided.

2. The self-light-emitting module according to claim 1, wherein

   the malfunction detection unit has a configuration bywhich an operation, by which malfunction in light emitting caused by defects in the light-emitting display panel, the lighting drive device, or the connecting portion between the light-emitting display panel and the lighting drive device is detected, can be executed at arbitrary timing under a state in which the self-light-emitting display module is installed in a device using the module.

3. The self-light-emitting module according to claim 1, wherein

   the malfunction detection unit has a configuration by which malfunction in light emitting of all pixels using the self light-emitting elements arranged on the light-emitting display panel can be detected.

4. The self-light-emitting module according to claim 2, wherein

   the malfunction detection unit has a configuration bywhich malfunction in light emitting of all pixels using the self light-emitting elements arranged on the light-emitting display panel can be detected.

5. The self-light-emitting module according to any one of claims 1 to 4, wherein

   themalf unction detection unit has a configuration bywhich the coordinate of a pixel using the self light-emitting element arranged on the light-emitting display panel can be detected.

6. The self-light-emitting module according to any one of claims 1 to 4, wherein

   themalf unction detection unit has a configuration bywhich a value of a current passing in the non-light-emitting direction of the self-light-emitting element can be measured.

7. The self-light-emitting module according to claim 5, wherein

   themalf unction detection unit has a configuration bywhich a value of a current passing in the non-light-emitting direction of the self-light-emitting element can be measured.

8. The self-light-emitting module according to claim 6, comprising

   a function by which a defect pattern in the light-emitting display panel, the lighting drive device, or the connecting portion between the light-emitting display panel and the lighting drive device is identified by the value of a current passing in the non-light-emitting direction of the self-light-emitting element.

9. The self-light-emitting module according to claim 7, comprising

   a function by which a defect pattern in the light-emitting display panel, the lighting drive device, or the connecting portion between the light-emitting display panel and the lighting drive device is identified by the value of a current passing in the non-light-emitting direction of the self-light-emitting element.

10. The self-light-emitting module according to claim 6, wherein

    the malfunction detection unit has a configuration by which the value of a current passing in the non-light-emitting direction of the self-light-emitting element is converted into a digital value.

**11.** The self-light-emitting module according to claim 7, wherein

the malfunction detection unit has a configuration bywhich the value of a current passing in the non-light-emitting direction of the self-light-emitting element is converted into a digital value.

**12.** The self-light-emitting module according to claim 8, wherein

the malfunction detection unit has a conf iguration by which the value of a current passing in the non-light-emitting direction of the self-light-emitting element is converted into a digital value.

**13.** The self-light-emitting module according to claim 9, wherein

the malfunction detection unit has a configuration bywhich the value of a current passing in the non-light-emitting direction of the self-light-emitting element is converted into a digital value.

**14.** The self-light-emitting module according to any one of claims 1 to 4, having

a configuration by which a storage notification unit is driven, based on detection of malfunction in light emitting by the malfunction detection unit.

**15.** The self-light-emitting module according to claim 5, having

a configuration by which a storage notification unit is driven, based on detection of malfunction in light emitting by the malfunction detection unit.

**16.** The self-light-emitting module according to claim 6, having

a configuration by which a storage notification unit is driven, based on detection of malfunction in light emitting by the malfunction detection unit.

**17.** The self-light-emitting module according to any one of claims 1 to 4, wherein

light-emitting elements arranged on the light-emitting display panel are organic EL elements using an organic compound for a light-emitting layer.

**18.** A method for verifying a defect state of a self-light-emitting display module comprising a light-emitting display panel in which a number of pixels using a self-light-emitting element with an electric polarity are arranged in a matrix manner, a lighting drive device for selective lighting drive of the self-light-emitting elements on the light-emitting display panel, a malfunction detection unit, by which malfunction in light emitting caused by defects in the light-emitting display panel, the lighting drive device, or a connecting portion between the light-emitting display panel and the lighting drive device is detected, wherein

the malfunction detection unit sequentially executes
a charge discharge step at which charges accumulated in the self-light-emitting elements arranged on the light-emitting display panel are discharged;
a current supply step at which a current is supplied in a non-light-emitting direction of the element concerned to the self-light-emitting under a state in which charges are discharged;
a current-value measure step at which a value of a current passing in a pixel including the self-light-emitting element after a predetermined time has passed from the starting point for supplying the current; and
a determination step at which the presence of a defect in the light-emitting display panel, the lighting drive device, or the connecting portion between the light-emitting display panel and the lighting drive device is determined by a value of a current measured at the current-value measure step, and
a storage notification unit is activated according to the defect state determined at the determination step.

**19.** The method for verifying a defect state of a self-light-emitting display module according to claim 18, wherein

the storage notification unit is activated according to a position of a defective pixel on the light-emitting display panel when the presence of a defect in a pixel arranged on the light-emitting display panel is identified at the determination step.

**20.** The method for verifying a defect state of a self-light-emitting display module according to claim 18 or 19, wherein

the charge discharge step, the current supply step, the current-value measure step, and the determination step are executed for each row or for each column of the self-light-emitting elements arranged in a matrix manner.

**FIG.1**

FIG.2

# FIG.3

**FIG.4**

START

ALL CATHODES AND ANODES OF EL ELEMENTS ARE EARTHED FOR CHARGE DISCHARGING. — S11

ALL CATHODE SIDES OF EL ELEMENTS ARE CONNECTED TO VM. — S12

ONE ANODE LINE IS EARTHED TO GND, AND ALL OTHER ANODE LINES ARE MADE IN HIGH IMPEDANCE. — S13

DEFECT INFORMATION IS RECORDED BY OBSERVING CHANGES IN CURRENT IM. — S14

HAS DEFECT INFORMATION BEEN RECORDED FOR ALL ANODE LINES ? — S15 — No

Yes

DEFECTIVE ANODE LINES ARE IDENTIFIED. — S16

ALL CATHODES AND ANODES OF EL ELEMENTS ARE EARTHED FOR CHARGE DISCHARGING. — S17

ONE DEFECTIVE ANODE LINE IS EARTHED TO GND, AND OTHER ANODE LINES ARE MADE IN HIGH IMPEDANCE. — S18

VM IS APPLIED TO ONE CATHODE LINE, OTHER CATHODE LINES ARE EARTHED TO GND, AND DEFECT INFORMATION IS RECORDED BY OBSERVING CHANGES IN CURRENT IM. — S19

HAS DEFECT INFORMATION BEEN RECORDED FOR ALL CATHODE LINES ? — S20 — No

Yes

HAVE S17 THROUGH S20 BEEN EXECUTED FOR ALL DEFECTIVE ANODE LINES IDENTIFIED AT S16 ? — S21 — No

Yes

END

# FIG.5

**FIG.6**

```
                    ┌─────────────┐
                    │   START     │
                    └─────────────┘
                           │
                           ▼
        ┌──────────────────────────────────────────┐   S31
        │ ALL CATHODES AND ANODES OF EL ELEMENTS    │
        │ ARE EARTHED FOR CHARGE DISCHARGING.       │
        └──────────────────────────────────────────┘
                           │
                           ▼
          ┌────────────────────────────────────┐     S32
          │ ALL ANODE LINES ARE EARTHED TO GND. │
          └────────────────────────────────────┘
                           │
                           ▼
    ┌──────────────────────────────────────────────────┐  S33
    │ VM IS APPLIED TO ONE CATHODE LINE, OTHER CATHODE  │
    │ LINES ARE EARTHED TO GND, AND DEFECT INFORMATION  │
    │ IS RECORDED BY OBSERVING CHANGES IN CURRENT IM.   │
    └──────────────────────────────────────────────────┘
                           │
                           ▼
   No    ╱────────────────────────────────────╲        S34
  ◄──────┤ HAS DEFECT INFORMATION BEEN RECORDED│
         │ FOR ALL CATHODE LINES ?             │
          ╲───────────────────────────────────╱
                           │ Yes
                           ▼
        ┌──────────────────────────────────────────┐   S35
        │ DEFECTIVE CATHODE LINES ARE IDENTIFIED.   │
        └──────────────────────────────────────────┘
                           │
                           ▼
       ╱────────────────────────────────────╲  Yes     S36
       ┤ IS NUMBER OF DEFECTIVE CATHODE      ├────────►
       │ LINES X OR MORE ?                   │
        ╲───────────────────────────────────╱
                           │ No
                           ▼
        ┌──────────────────────────────────────────┐   S37
        │ ALL CATHODES AND ANODES OF EL ELEMENTS    │
        │ ARE EARTHED FOR CHARGE DISCHARGING.       │
        └──────────────────────────────────────────┘
                           │
                           ▼
    ┌──────────────────────────────────────────────────┐  S38
    │ ONE ANODE LINE IS EARTHED TO GND,                 │
    │ AND ALL OTHER ANODE LINES ARE MADE IN HIGH        │
    │ IMPEDANCE.                                        │
    └──────────────────────────────────────────────────┘
                           │
                           ▼
    ┌──────────────────────────────────────────────────┐  S39
    │ VM IS SUPPLIED TO ONE OF DEFECTIVE CATHODE LINES, │
    │ OTHER CATHODE LINES ARE EARTHED TO GND,           │
    │ AND DEFECT INFORMATION IS RECORDED                │
    │ BY OBSERVING CHANGES IN CURRENT IM AT THIS TIME.  │
    └──────────────────────────────────────────────────┘
                           │
                           ▼
   No    ╱────────────────────────────────────╲        S40
  ◄──────┤ HAS DEFECT INFORMATION              │
         │ BEEN RECORDED FOR ALL ANODE LINES ? │
          ╲───────────────────────────────────╱
                           │ Yes
                           ▼
   No    ╱────────────────────────────────────╲        S41
  ◄──────┤ HAVE S37 THROUGH S40 BEEN EXECUTED FOR│
         │ ALL DEFECTIVE CATHODE LINES IDENTIFIED AT S35 ?│
          ╲───────────────────────────────────╱
                           │ Yes
                           │        ┌──────────────────┐  S42
                           │◄───────│ DETERMINATION     │
                           │        │ THAT MODULE IS NG.│
                           ▼        └──────────────────┘
                    ┌─────────────┐
                    │   E N D     │
                    └─────────────┘
```

**FIG.7**